# EUROPEAN PATENT SPECIFICATION

(11) **EP 0 563 993 B1**
(45) Date of publication and mention of the grant of the patent: **15.01.1997**
(21) Application number: 93105521.4
(22) Date of filing: 02.04.1993
(51) Int. Cl.: H05K 7/20

(54) **Electronic unit cooling system**
Kühlanlage für elektronische Einheit
Système de refroidissement pour ensemble électronique

(30) Priority: 03.04.1992 JP 81192/92; 10.02.1993 JP 21552/93
(43) Date of publication of application: 06.10.1993
(73) Proprietor: FUJI ELECTRIC CO., LTD., Kawasaki-shi Kanagawa 210 (JP)
(72) Inventor: Higashi, Izumi, c/o Fuji Electric Co., Ltd., Kawasaki-shi, Kanagawa (JP)
(74) Representative: Grünecker, Kinkeldey, Stockmair & Schwanhäusser Anwaltssozietät

(56) References cited:
- EP-A- 0 313 473
- MACHINE DESIGN, vol.63, no.14, 11 July 1991, Cleveland,Ohio,US pages 73 - 76 R.REMSBURG:'New routes to cooler electronics'
- FUJITSU SCIENTIFIC & TECHNICAL JOURNAL, vol.23, no.4, 1987, Kawasaki,JP, pages 243 - 254 H.YAMAMOTO et al.:'Cooling system for the facom m-780'
- IBM TECHNICAL DISCLOSURE BULLETIN, vol.27, no.7B, December 1984 C.W.ELLIS:'Electronic substrate cooling device'
- DATABASE WPI Week 8218, Derwent Publications Ltd., London, GB; AN 82-35810E;& JP-A-57 049 852

## Description

### BACKGROUND OF THE INVENTION

### Field of the Invention

The invention relates to a system for cooling electronic units having mounted semiconductor elements (ICs, LSIs, thyristors, IGBTs, etc.) that produce excessive heat, such as in large computers and electronic power devices.

As semiconductor elements such as ICs and LSIs, have been further downsized and integrated, heat generated per unit volume of a chip (surface heat density) tends to increase. Due to higher integration, the surface heat density of a typical IC or LSI chip is elevated from a previous maximum level of about 3W/cm² to 10W/cm² or more. To control the junction temperature of a semiconductor element having a high surface heat density mounted on an electronic unit within an allowable level, it is necessary to provide a smaller cooling system with high cooling performance so as to match the downsizing of the electronic unit.

### Discussion of the Related Art

Previously, semiconductor elements, such as ICs or LSIs, have been cooled by: air cooling or forced air cooling by natural convection; water cooling in which cooling water is circulated directly to a heat sink combined with the semiconductor element; cooling by boiling in which the semiconductor element is immersed in a low boiling point nonelectrically conducting cooling medium solution directly; and cooling with a heat pipe.

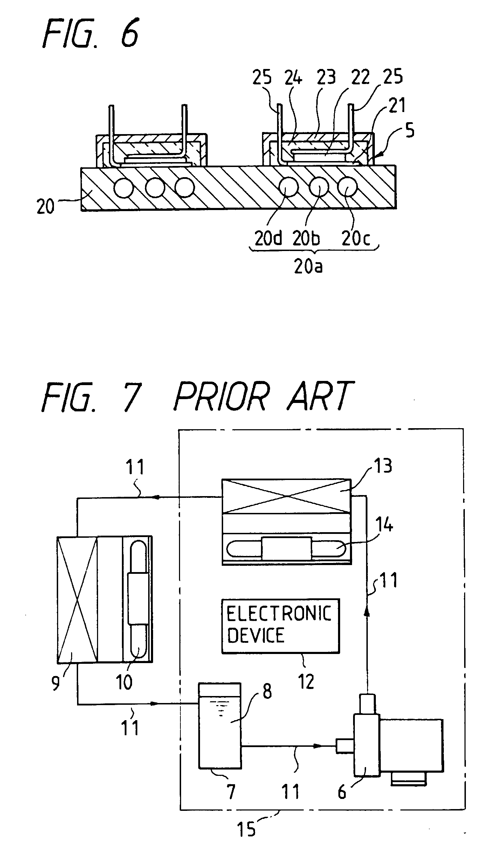

Figure 7 shows a cooling system in which an electronic unit 12, incorporated in a frame 15, is cooled by forced air. That is, inside the frame 15 is an electronic unit 12 including semiconductor elements; a tank 7 for containing a cooling medium solution 8; a cooling medium solution circulation pump 6; and an air cooled heat exchanger 13 having a fan 14 for cooling air within the frame with the cooling medium solution serving as a cooling source. Outside the frame 15 is a radiator 9 that is combined with a fan 10. The radiator 9 is connected with the pump 6, the tank 7, and the heat exchanger 13 in series by a solution supply pipe 11 to constitute a cooling medium circulating circuit.

The thus constructed cooling system circulates the cooling medium solution 8 through the air cooled heat exchanger 13 and the radiator 9, whereby heat is exchanged between the cooling medium solution 8 and the air within the frame is cooled by heat exchanger 13, and the cooled air is then blown onto electronic unit 12 by the fan 14. As a result, the semiconductor elements incorporated in the electronic device 12 are forcibly cooled.

However, it is difficult to handle the cooling requirements of such highly integrated semiconductor elements whose surface heat density exceeds 10W/cm² with conventional cooling systems. Particularly, since the cooling system shown in Figure 7 transfers heat generated in the semiconductor elements to the air cooled heat exchanger using ambient air, it is difficult to efficiently cool such semiconductor elements having a high surface heat density to an allowable temperature level, as in the case of highly integrated ICs and LSIs, without resorting to a cooling system that is larger in structure than the electronic unit itself.

An apparatus for supplying cooling liquids is for example described in EP 0 313 473. Printed circuit boards are mounted on cooling modules, one module for each printed circuit board. On each circuit board, various heat generating elements are provided. Each cooling module is supplied with cooling liquid by its own pump system with one heat-exchanger each. All cooling circuits are supplied by one liquid tank.

The cooling module can be constituted of cold plates, as for example, described in Machine Design, vol. 63, no. 14, 11.07.91, Cleveland, OH, USA, pages 73-76. These cold plates can be fabricated from heat conducting ceramics (IBM Technical Disclosure Bulletin, vol.27, No.7b, December 1984, page 4420), for example, ceramics composed of silicon carbide, as disclosed in Database, WPI, Week 8218, Derwent Publications Ltd. London, GB, An 82-35 810E.

### SUMMARY OF THE INVENTION

The invention has been made in view of the above circumstances. Accordingly, the object of the invention is to overcome the above problem by providing an electronic unit cooling system that is capable of effectively cooling semiconductor elements having a large surface heat density in an efficient and economical manner.

To achieve the above object, the invention as defined in claim 1 provides a cooling system that includes: a cold plate having a plurality of semiconductor elements collectively mounted in surface contact thereon so as to transmit heat from the semiconductor elements to the cold plate; and a cooling medium solution circulating circuit for circulating the cooling medium through a radiator, a cooling medium solution circulation pump, and a cooling medium solution containing tank via cooling medium solution flow paths arranged in the cold plate. The cooling medium solution flow paths are arranged so that each flow path extends beneath a corresponding row of semiconductor elements mounted on the cold plate so as to confront the semiconductor elements.

The cooling system of the present invention possesses the following features.
(1) Each cooling medium solution flow path corresponding to the semiconductor elements mounted on a cold plate is arranged so that the cooling medium solution flow path divides into a plurality of branches, and such branches extend so as to confront each semiconductor element. In addition, one of the branches is arranged so as to confront a central portion of the semiconductor element.
(2) Fluorocarbon is preferably used as the cooling medium solution.
(3) Recessed and projected portions are preferably provided on the inner wall surface of each cooling medium solution flow path arranged in the cold plate.
(4) The cold plate is preferably made of a ceramic plate that is highly heat conductive; the plate also serving as the package for a semiconductor element.
(5) A air cooled heat exchanger is preferably connected to the cold plate either in parallel or in series, the air cooled by the heat exchanger is blown on other electronic devices incorporated in the frame with a cooling medium solution circulating through the cooling medium solution circulating circuit serving as a cooling source.

The cooling medium solution flow paths are arranged in the cold plate so that each flow path extends below a corresponding row of semiconductor elements mounted on the cold plate so as to confront the semiconductor elements. As a result of this construction, the heat transfer distance between each cooling medium solution flow path and each semiconductor element can be minimized, thereby reducing heat transfer resistance between the cooling medium solution flowing through the cooling medium solution flow path and the semiconductor element. Also, since heat built up in the semiconductor element is more concentrated in the central portion than in the periphery of the semiconductor element, each cooling medium solution flow path is branched out into a plurality of branches, e.g. three branches, so as to correspond to the heat distribution in the semiconductor element, and one of the branches is positioned so as to confront a central portion of the semiconductor element. As a result of this construction, not only is the heat transfer area between the cold plate and the cooling medium solution flowing through the cooling medium solution flow path increased, but also heat produced by the semiconductor element is effectively transferred to the cooling medium solution. This achieves high heat transmittance. The recessed and projected portions, such as provided by screw threads, are formed over the inner wall surface of each cooling medium solution flow path to further improve heat transfer, by promoting turbulence effects in the cooling medium solution.

In addition, the cold plate is made of a highly heat conductive ceramic plate, such as aluminum nitride or silicon carbide, so that the cold plate can also serve as the package for a semiconductor element when the cold plate is used as a base plate, semiconductor element chips are directly mounted thereon to form the package of the semiconductor element. As a result of this construction, heat transfer resistance between the chips and the cold plate is further reduced, thereby further improving heat transmittance between the cold plate and the cooling medium solution. In addition, the assembled structure is simplified to a great degree, and the cold plate is free from corrosion regardless of the types of cooling medium solutions utilized.

Further, the cold plate that mounts the semiconductor elements is connected to the air cooled heat exchanger for cooling the air within the frame of an electronic unit, with the circulating cooling medium solution as a cooling source flowing in parallel or series therewith. As a result of this construction, an electronic device that generates considerable heat, such as a back board, a printed wiring board mounting control circuits incorporated in the frame together with the semiconductor elements such as LSIs, can be forcibly air cooled simultaneously, while sharing the same cooling source in common. Embodiments of the invention will be described with reference to the drawings.

### BRIEF DESCRIPTION OF THE DRAWINGS

Figure 1 is a flow diagram of a cooling system constructed in accordance with a first embodiment of the invention;
Figure 2 is a flow diagram of a cooling system constructed in accordance with a second embodiment of the invention;
Figure 3 is a plan view showing a cold plate and an arrangement of semiconductor elements mounted on the cold plate according to the present invention;
Figure 4 is a partial sectional view of a cooling medium solution flow path in the cold plate according to an embodiment of the invention;
Figure 5 is a sectional view showing a main portion of an assembled structure of the cooling system according to another embodiment of the invention;
Figure 6 is a sectional view showing a main portion of an assembled structure of a cooling system according to yet another embodiment of the invention; and
Figure 7 is a flow diagram of a conventional electronic element cooling system.

### DETAILED DESCRIPTION OF THE PREFERRED EMBODIMENTS

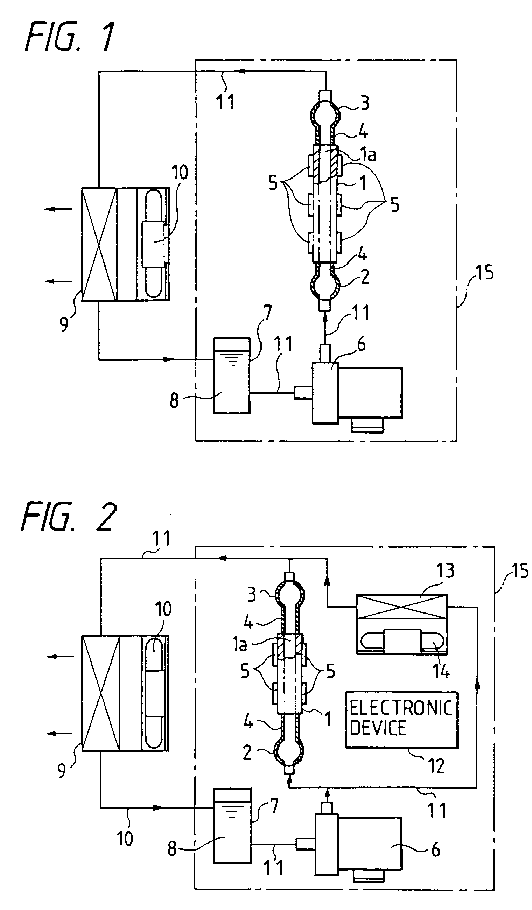

Figures 1 and 2 show flow diagrams of cooling systems, which are the embodiments of the invention. In Figures 1 and 2, reference numeral 1 designates a cold plate; 1a, tunnel-like cooling medium solution flow paths arranged inside the cold plate 1; 2, 3, headers connected to conduits 4 on an inlet and an outlet of the cold plate 1; 5, semiconductor elements such as LSIs that generate excessive heat; 6, a cooling medium solution circulation pump; 7, a cooling medium solution containing tank; 8, a fluorocarbon solution used as a cooling medium solution; 9, a radiator serving as an air cooled heat exchanger; 10, an air supply fan provided in radiator 9; 11, a solution supply pipe of a cooling medium solution circulating circuit; 12, an electronic device (Figure 2) such as a back board that is incorporated in the frame of an electronic unit together with the semiconductor elements 5 that generates less heat than the semiconductor elements; 13, an air cooled heat exchanger provided inside the frame of the electronic unit; 14, an air supply fan provided with the air cooled heat exchanger 13; and 15, the frame of the electronic unit.

### [Embodiment 1]

In Figure 1, semiconductor elements 5 producing excessive heat such as highly integrated LSIs are mounted on the surface of the cold plate 1 in surface contact therewith. The cold plate 1 is connected to the cooling medium solution circulating circuit with the cooling medium solution circulation pump 6, the tank 7 containing the fluorocarbon solution 8, and the radiator 9 by the solution supply pipe 11. The tank 7 not only serves as a damper for absorbing expansion and contraction of the fluorocarbon solution 8 brought about by changes in temperature, but also plays the role of stabilizing the suction of the pump 6. C₅F₁₂ (boiling point: 30°C at atmospheric pressure), C₆F₁₄ (boiling point: 56°C), C₈F₁₆O (boiling point: 101°C) or the like can be used as the fluorocarbon solution 8.

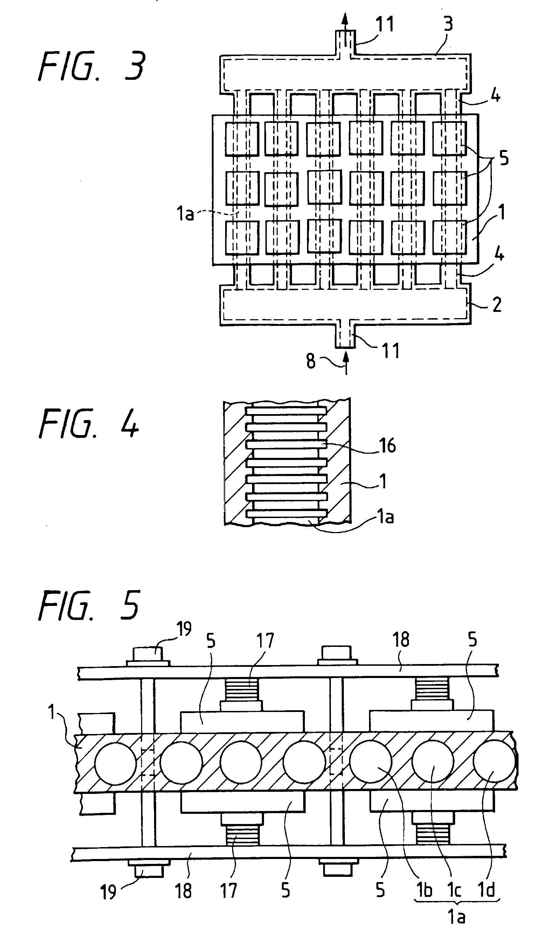

The cold plate 1 is made of a highly heat transmitting metallic material. As shown in Figure 3, a plurality of semiconductor elements 5 are mounted on a single surface or on several surfaces of the cold plate 1 in a matrix arrangement. A plurality of cooling medium solution flow paths la are arranged in the cold plate 1 so as to extend under the semiconductor elements, each flow path corresponding to a single row of semiconductor elements 5 mounted on the cold plate. Each cooling medium solution flow path 1a runs between the headers 2 and 3 in parallel.

When the cooling medium solution circulation pump 6 and the air supply fan 10 are driven during the operation of the electronic unit using the thus constructed apparatus, the fluorocarbon solution 8 serving as a cooling medium solution is circulated between the cold plate 1 and the radiator 9. Heat transmitted to the cold plate 1 from the semiconductor elements 5 is carried away by the fluorocarbon solution 8 as the fluorocarbon solution 8 flows through the cooling medium solution flow paths la in the cold plate 1. The heat absorbed by the fluorocarbon solution 8 is then transferred to the radiator 9, which discharges the heat out of the system to decrease the temperature of the system. Then, the fluorocarbon solution 8 continues recycling into the flow paths 1a in the cold plate 1 after decreasing the temperature. Since the cooling medium solution flow paths la are arranged in the cold plate 1 so that the flow paths run below the surface of the cold plate 1 on which the semiconductor elements 5 are mounted in such a manner that a separate flow path underlies each row of semiconductor elements 5, the heat transfer distance with respect to the semiconductor elements 5 (i.e., heat transfer resistance) is minimized. Further, since the fluorocarbon solution 8, which has a low boiling point, is circulated forcibly, nuclear boiling effects are created, and heat built up in the semiconductor elements can be transferred efficiently to the fluorocarbon solution 8 flowing through the cooling medium solution flow paths la and then expelled from the system.

Practical embodiments of the invention are shown in Figures 4, 5, and 6.

The construction shown in Figure 4 is characterized as providing grooves 16 so that the wall surface of each cooling medium solution flow path 1a, which is in the form of a tubular passage, has recesses and projections. Such construction not only increases the heat transfer surface area between the cold plate 1 and the cooling medium solution flowing through the cooling medium solution flow path 1a, but also improves heat transfer characteristics, encouraged by turbulence effects induced in the cooling medium solution flow.

In the construction shown in Figure 5, the semiconductor elements 5 are mounted on opposed surfaces of the cold plate 1 and are biased against the plate surface by the provision of tightening bolts 19 through biasing springs 17 and biasing plates 18. Further, the cooling medium solution flow paths 1a in the cold plate 1 are in the form of three branches 1b to 1d. The three branches respectively extend along the right, the left, and the middle of a confronting package of each semiconductor element 5. The middle branch 1c confronts a central portion across the semiconductor element that exhibits the highest surface heat density in the heat distribution across the semiconductor element. As a result of this construction, the heat transfer area (a sum of the surface areas of the three branches 1b to 1d) of the cooling medium solution flow paths 1a is increased. Further, since the heat transfer distance between the central portion at which the surface area heat density is highest and the cooling medium solution flow path is shortest, heat transfer resistance, between the semiconductor element 5 and the cooling medium solution flowing through the branches 1b to 1d is reduced, thus achieving efficient heat removal.

Figure 6 shows another embodiment of the invention, which is a derivative of the above-described embodiment. This embodiment employs a cold plate 20 made of a ceramic that is highly heat conductive instead of the metallic cold plate 1 used in the above-described embodiments. Packages of the semiconductor elements are formed while mounting the semiconductor elements 5 directly on cold plate 20. That is, a bare chip 22, such as an LSI, is mounted on the upper surface of the cold plate 20 through a copper base 21. An outer enclosing case 23 is filled with a sealing resin 24 over the chip 22 to form a package for the semiconductor element 5. In Figure 6, reference numerals 20a, 20b to 20d designate cooling medium solution flow paths corresponding to the branches 1b to 1d; and 25, an output leads for chips 22.

Because of above-described construction, the package of the semiconductor element 5 is in part provided by directly mounting the chip 22 of the semiconductor element 5 on the ceramic cold plate 20, with the cold plate 20 itself serving as a radiating base. This not only makes the entire assembled structure simple, but also further reduces heat transfer resistance between the cold plate 20 and the chip 22, which is the heat generating body. As a result, cooling performance is further improved. In addition, the cold plate 20, being made of a ceramic, is completely free from corrosion, regardless of the types of cooling medium solutions utilized.

### [Embodiment 2]

In the second embodiment seen in Figure 2, the cold plate 1 and the air cooled heat exchanger 13 for cooling the semiconductor elements are provided within the frame 15 of the electronic unit. The air cooled heat exchanger 13 is connected to the cold plate 1 in parallel (or in series) with the cooling medium solution circulating circuit. The air cooled heat exchanger 13 is provided to forced-air cool the electronic device 12 that is incorporated in the frame 15. Similar to the cold plate 1, air in the frame 15 is cooled by exchanging heat at the air cooled heat exchanger 13 with the fluorocarbon solution (cooling medium solution) 8 flowing through the cooling medium solution circulating circuit as a cooling source. The cooled air forced through heat exchange 13 by the air supply fan 14 is blown on the electronic device 12 to remove the heat generated by the device.

This construction allows both the semiconductor elements 5 and the electronic device 12 to be cooled simultaneously by simply adding the air cooled heat exchanger 13 to the semiconductor element 5 cooling system.

As described in the foregoing pages, the cooling system of the invention provides the following advantages.
(1) The cooling medium solution flow paths of the cold plate are arranged so that each flow path extends below a corresponding row of semiconductor elements mounted on the cold plate, and the cooling medium solution is forcibly circulated through each cooling medium solution flow path. As a result, heat transfer resistance between the semiconductor element and the cooling medium solution can be reduced, which allows efficient removal of the heat built up in the semiconductor elements. This further allows semiconductor elements having a large surface heat density such as LSIs to be cooled with a physically smaller cooling system.
(2) The fluorocarbon solution, whose boiling point is low, is forcibly circulated through the cooling medium solution flow paths as the cooling medium solution, thereby further improving heat transmittance between the semiconductor elements and the cooling medium solution, encouraged by nuclear boiling effects.
(3) By arranging branches of each cooling medium solution flow path to respectively correspond to rows of semiconductor elements mounted on the cold plate in such a manner that the branches extend so as to confront each semiconductor element, and also arranging one of the branches so as to confront a central portion of the semiconductor element where the highest surface heat density in the heat distribution of the semiconductor element occurs, heat transmitting area between the cold plate and the cooling medium solution flowing through the cooling medium solution flow paths is increased, and the heat generated in the semiconductor elements is effectively transmitted to the cooling medium solution, thereby achieving high heat transmittance.
(4) By forming recessed and projected portions over the inner surface of each cooling medium solution flow path of the cold plate, heat transmission from the semiconductor elements can be further improved, promoted by turbulence effects induced in the cooling medium solution flow.
(5) By forming the cold plate of a highly heat conductive ceramic plate and also forming the package of each semiconductor element while directly mounting the semiconductor element with the cold plate as a base plate therefor, heat transfer resistance between the chip and the cold plate is further reduced, and heat transmittance between the semiconductor element and the cooling medium solution is improved. In addition, the assembled structure becomes simple, and the cold plate is free from corrosion regardless of the types of codling medium solutions utilized.
(6) By connecting the cold plate in parallel or in series with a air cooled heat exchanger for cooling an electronic device incorporated in the frame and blowing air cooled by the cooling medium solution flowing through the cooling medium solution circulating circuit as a cooling source onto the electronic device; an electronic device that is less heat-dissipating, such as a back board (a printed wiring board on which control circuits are mounted) incorporated in the frame together with the semiconductor elements such as LSIs, can be forcibly air cooled simultaneously using the same cooling source utilized in cooling semiconductor elements.

The foregoing description of preferred embodiments of the invention has been presented for purposes of illustration and description. It is not intended to be exhaustive or to limit the invention to the precise form disclosed, and modifications and variations are possible in light of the above teachings or may be acquired from practice of the invention. The embodiments were chosen and described in order to explain the principles of the invention and its practical application to enable one skilled in the art to utilize the invention in various embodiments and with various modifications as are suited to the particular use contemplated. It is intended that the scope of the invention be defined by the claims appended hereto.

## Claims

1. A system for cooling an electronic unit including a plurality of heat generating semiconductor elements (5), said system comprising:
a plate (1) collectively mounting said semiconductor elements (5) in surface contact therewith, such that heat is transferred from said semiconductor elements (5) to said plate (1); and
a circulating circuit including:
a radiator (9);
a flow path (1a) in said plate (1);
a supply pipe (11);
a tank (7) containing a cooling medium solution (8); and
a pump (6) for circulating the cooling medium (8) through said radiator (9), said flow path (1a) and said tank (7) and said supply pipe (11);
**characterized in that**
said plate (1) is formed as a cold plate (1) and
said flow path (1a) includes plural branches respectively arranged in confronting relation with said semiconductor elements (5) and positioned such as to confront at least central portions of the semiconductor elements (5); and
said system comprises headers (2,3) dividing said supply pipe (11) into said plural branches of said flow path (1a).

2. The system of claim 1, wherein the semiconductor elements (5) are arranged in plural rows.

3. The system of claim 2, wherein each of the flow paths (1a) confronting said semiconductor elements (5) arrayed in a row comprises three branches (1b,1c,1d), the central branch (1c) thereof confronting the central portion of said semiconductor elements (5).

4. The system of one of the preceding claims, wherein said cooling medium solution is a fluorocarbon.

5. The system of one of the preceding claims, wherein said flow paths (1a) include an interior wall surface formed with recessed and projected portions.

6. The system of one of the preceding claims, wherein said cold plate (1) is comprised of a highly heat conductive ceramic material having a mounting surface for the semiconductor elements (5) that also provides packaging portions for semiconductor elements (5).

7. The system of one of the preceding claims, wherein said circulating circuit further includes an air cooled heat exchanger (13) connected with said cold plate (1) for blowing cooling air on an electronic device (12) incorporated with the semiconductor elements (5) in a frame (15).

8. The system of one of the preceding claims, wherein said cold plate (1) is formed of a highly conductive ceramic material selected from a group including aluminum nitride and silicon carbide.

## Patentansprüche

1. Ein Kühlsystem zur Kühlung einer elektronischen Einheit, das eine Vielzahl von wärmeerzeugenden Halbleiterelementen (5) umfaßt, wobei das System folgendes umfaßt:
eine Platte (1), auf der die Halbleiterelemente (5) zusammen in Oberflächenkontakt damit befestigt sind, so daß Wärme von den Halbleiterelementen (5) zu der Platte (1) übermittelt wird; und
ein Zirkulationskreislauf, der folgendes umfaßt:
einen Radiator (9);
einen Strömungsweg (1a) in der Platte (1);
eine Zuführungsleitung (11);
einen Tank (7), der eine Kühlmittellösung (8) enthält; und
eine Pumpe (6) zum Zirkulieren des Kühlmittels (8) durch den Radiator (9), den Strömungsweg (1a), den Tank (7) und die Zuführungsleitung (11);
**dadurch gekennzeichnet**, daß
die Platte (1) als Kaltplatte (1) ausgebildet ist und
der Strömungsweg (1a) mehrere Zweige umfaßt, die entsprechend in gegenüberliegender Beziehung zu den Halbleiterelementen (5) angeordnet sind und derart positioniert sind, daß sie mindestens Zentralbereichen der Halbleiterelemente (5) gegenüberstehen; und
das System Kopfteile (2, 3) umfaßt, die die Zuführungsleitung (11) in die mehreren Zweige des Strömungsweges (1a) aufteilen.

2. Ein System nach Anspruch 1, wobei die Halbleiterelemente (5) in mehreren Reihen angeordnet sind.

3. System nach Anspruch 2, wobei jeder der Strömungswege (1a), die den Halbleiterelementen (5), die in einer Reihe angeordnet sind, gegenüberstehen, drei Zweige (1b, 1c, 1d) umfaßt, wobei der zentrale Zweig (1c) davon dem Zentralbereich des Halbleiterelementes (5) gegenübersteht.

4. System nach einem der vorhergehenden Ansprüche, wobei die Kühlmittel lösung ein Fluorkohlenstoff ist.

5. System nach einem der vorhergehenden Ansprüche, wobei die Strömungswege (1a) eine innere Wandoberfläche umfassen, die mit zurückgesetzten und vorstehenden Bereichen ausgebildet ist.

6. System nach einem der vorhergehenden Ansprüche, wobei die Kaltplatte (1) aus einem hochwärmeleitfähigen keramischen Material aufgebaut ist, das eine Befestigungsoberfläche für die Halbleiterelemente (5) hat, das auch Baugruppenbereiche für Halbleiterelemente (5) bereitstellt.

7. System nach einem der vorhergehenden Ansprüche, wobei der Zirkulationskreislauf weiterhin einen luftgekühlten Wärmetauscher (13) aufweist, der mit der Kaltplatte (1) verbunden ist, um Kühlluft auf ein elektronisches Gerät (12) zu blasen, das mit den Halbleiterelementen (5) in einem Rahmen (15) eingebaut ist.

8. System nach einem der vorhergehenden Ansprüche, wobei die Kaltplatte (1) aus einem hochwärmeleitfähigen keramischen Material aus einer Gruppe ausgewählt ist, die Aluminiumnitrid und Siliciumcarbid enthält.

## Revendications

1. Système pour le refroidissement d'une unité électronique comprenant une pluralité d'éléments à semi-conducteur générant de la chaleur (5), ledit système comprenant :
- une plaque (1) supportant, de façon collective, lesdits éléments à semi-conducteur générant de la chaleur (5) en contact de surface de telle façon que la chaleur soit transférée desdits éléments à semi-conducteur générant de la chaleur (5) à ladite plaque (1); et
- un circuit de circulation comprenant :
- un radiateur (9);
- un circuit de circulation (1a) dans ladite plaque (1);
- une conduite d'alimentation (11);
- un réservoir (7) contenant une solution de milieu de refroidissement (8); et
- une pompe (6) pour la circulation du milieu de refroidissement (8) dans ledit radiateur (9), ledit circuit de circulation (la) et ledit réservoir (7) ainsi que ladite conduite d'alimentation (11);
système caractérisé en ce que :
- ladite plaque (1) est formée d'une plaque froide (1); et
- ledit circuit de circulation (1a) comprend plusieurs dérivations agencées, de façon respective, en vis-à-vis avec lesdits éléments à semi-conducteur générant de la chaleur (5) et positionnées de façon à faire face à au moins les parties centrales des éléments à semi-conducteur générant de la chaleur (5); et
- ledit système comprend des têtes (2, 3) divisant ladite conduite d'alimentation (11) en ladite pluralité de dérivations dudit circuit de circulation (1a).

2. Système selon la revendication 1, dans lequel les éléments à semi-conducteur générant de la chaleur (5) sont agencés en plusieurs rangées.

3. Système selon la revendication 2, dans lequel chacun des circuits de circulation (1a) faisant face auxdits éléments à semi-conducteur générant de la chaleur (5) placés dans une rangée comprend trois dérivations (1b, 1c, 1d), la dérivation centrale (1c) faisant face à la partie centrale desdits éléments à semi-conducteur générant de la chaleur (5).

4. Système selon l'une quelconque des revendications précédentes, dans lequel ladite solution de milieu de refroidissement est du fluorocarbone.

5. Système selon l'une quelconque des revendications précédentes, dans lequel lesdits circuits de circulation (1a) comprennent une surface de paroi interne munie de parties en creux et en projection.

6. Système selon l'une quelconque des revendications précédentes, dans lequel ladite plaque froide (1) est constituée d'un matériau de céramique très fortement conductrice de la chaleur possédant une surface de montage pour les éléments à semi-conducteur générant de la chaleur (5) constituant, de même, des parties de boîtier pour les éléments à semi-conducteur générant de la chaleur (5).

7. Système selon l'une quelconque des revendications précédentes, dans lequel ledit circuit de circulation comprend, de plus, un échangeur de chaleur refroidi par air (13) raccordé à ladite plaque froide (1) pour souffler de l'air de refroidissement sur un dispositif électronique (12) incorporé aux éléments à semi-conducteur générant de la chaleur (5) dans un cadre (15).

8. Système selon l'une quelconque des revendications précédentes, dans lequel ladite plaque froide (1) est formée d'un matériau de céramique fortement conductrice choisi dans un groupe comprenant du nitrure d'aluminium et du carbure de silicium.
